# EUROPEAN PATENT SPECIFICATION

(11) **EP 0 597 990 B1**
(45) Date of publication and mention of the grant of the patent: **10.05.2000**
(21) Application number: 92917136.1
(22) Date of filing: 10.08.1992
(51) Int. Cl.: G06F 1/18, H05K 7/14

(54) **DATA HANDLING APPARATUS COMPRISING A PLURALITY OF STACKABLE LAYERS**
AUS EINEM STAPEL VON MODULEN BESTEHENDE DATENVERARBEITUNGSANLAGE
APPAREIL DE TRAITEMENT DE DONNEES COMPRENANT UN ENSEMBLE DE COUCHES EMPILABLES

(30) Priority: 08.08.1991 GB 91171488
(43) Date of publication of application: 25.05.1994
(73) Proprietor: SKIMMING, William, Glen, Neath Hill, Milton Keynes MK14 6HU (GB)
(72) Inventor: SKIMMING, William, Glen, Neath Hill, Milton Keynes MK14 6HU (GB)
(74) Representative: Crawford, Andrew Birkby
(86) International application number: GB9201485
(87) International publication number: WO9303432

(56) References cited:
- EP-A- 0 478 121
- WO-A-87/02800
- GB-A- 2 191 896
- US-A- 5 016 138

## Description

The present invention relates to computer data handling circuitry. The term "data handling" is intended to be a broad term Covering inter alia data processing, storage or transfer.

The present invention is best described in terms of data processing although it is not limited to this aspect of data handling. Data processing circuitry is normally distributed over a number of processing units which are either mounted on a single board or on a number of printed circuit boards which are connected or linked together via some suitable coupling system. In either case, some kind of protocol allows communication between the printed circuit boards and/or processors. While these arrangements have been satisfactory up to the present time, manufacturers recognise that the existing layouts have become restrictive since in general they require closed architecture with a fixed or very limited means of communication between circuit boards or processing units. In other words, once a data processing apparatus has been designed, it in general cannot be upgraded without complete redesign. The alternative is to design the upgrade initially but not fully implement the system. One example of this is the provision of a space for a co-processor.

A further problem has arisen recently due to the desire to increase data rates to an ever greater degree. As a consequence, data rates have increased such that propagation times along conductors are now significant when considering the design of the circuitry. Care has to be taken when data buses run close together in view of the fact that there is a possibility of bus contention problems when data is present on adjacent buses.

The need to deal with increasing data rates has meant more and more attention to the architecture of the circuitry which, rather than making the architecture more open, has had the opposite effect.

It is clear that existing circuit constructions using multiple printed circuit boards with the processors distributed over the printed circuit boards is not a viable way forward.

It has already been proposed to utilize a 3-dimensional connector system such as is described in GB-A-2191896 in order to save space and improve the ability to upgrade circuits. The connector system described in the UK patent allows individual chips or small circuit boards to be connected together in stacks which in turn may be connected to each other. Such an arrangement is potentially very useful in view of the ability to modify circuits very easily and to make a large number of connections but it does result in a degree of complexity if only due to the 3-dimensional nature of the circuitry.

The present invention has as an object to improve upon the basic circuit construction utilizing a 3-dimensional interconnection system such as, for example, the one described in GB-A-2191896.

The present invention as defined in claim 1 provides a circuit assembly comprising a substrate having a conductive pattern on at least a portion of one major surface. A stack comprising a plurality of spacers is mounted on the conductive pattern and forms the data handling circuit. Each of the spacers carries a small circuit board or chip carrier provided with one or more circuit elements and comprises an insulating frame with coupling means on both upper and lower surfaces. The spacers are stacked one on top of the other. When the coupling means are in the form of electrically conductive contacts, the lower contacts of an upper connector in electrical contact with pads on the upper surface of the circuit board of the adjacent lower spacer and the upper contacts in contact with pads on the lower surface of the circuit board of the adjacent upper spacer whereby to create conductive paths up and down the stack by selectively plating from one surface to the other of each small circuit board or chip carrier. Each circuit board forms all or part of a circuit having a specific function. The coupling means around each spacer frame are grouped together into sections with each contact having a specific function and the stack of insulating frames may be notionally partitioned in a vertical direction so that conductive paths up and down the stack form a hierarchical bus structure with the most general, slowest bus at the bottom of the stack the least general, most device specific and fastest bus at the top of the stack.

A communication controller circuit is present in the bottom connector closest to the substrate to control allocation of data to and/or from circuit resources such as input or output devices and memory. The communication controller circuit is preferably accompanied by a power monitor circuit on the same level or on the immediately above level. Power monitor circuits according to the present invention comprise a constant current power supply unit, a shunt regulator, a virtual earth and multiple clock circuits (optional). The shunt regulator is used to deliver power to a load and by design has a frequency bandwidth which, coupled with the constant current source is used to prevent data empathy transmissions on the power rails since the frequency bandwidth corresponds to the range of frequencies of the clock signals in use by the circuit assembly. The power monitor circuits are used for applications where power consumption is to be kept to a minimum and can be used to detect faulty conditions and cause the circuitry with which they are associated to be shut down. Preferably there is one power monitor unit per level of the stack whereby to provide a distributed power supply.

The number of spacers and hence small circuit boards in a stack is variable depending on the complexity of the overall circuit to be constructed. Typically six or eight spacers can be used but up to fourteen or fifteen spacers can be stacked if necessary. The spacers are joined together in some convenient manner either by being clipped together or by means of bolts or screws extending the full height of the stack so as to positively retain each stack on the substrate. When bolts or screws are present in the stack, heat transfer from the stack to the substrate can be achieved utilizing the bolts or screws.

In order that the present invention may be more clearly understood, embodiments thereof will be described with reference to the accompanying drawings in which:
Fig. 1a shows a diagrammatic side view of a stack of connectors constituting a circuit assembly; and Fig. 1b shows a diagrammatic plan view of the arrangement shown in Fig. 1a;
Fig. 2 shows a side view of a part of the stack shown in Fig. 1a. but in more detail;
Figs. 3a to 3h show diagrammatically typical constructions for each of individual layers which can be used in the stack shown in Fig. 1a;
Fig. 4 shows how two stacks could be connected together;
Fig. 5 is a diagrammatic side view through adjacent layers of a stack for explaining heat dissipation;
Fig. 6 is an explored sectional side view through a substance used in the stack shown in Fig. 5; and
Fig. 7 shows a block diagram of a communication control circuit used by the present invention.

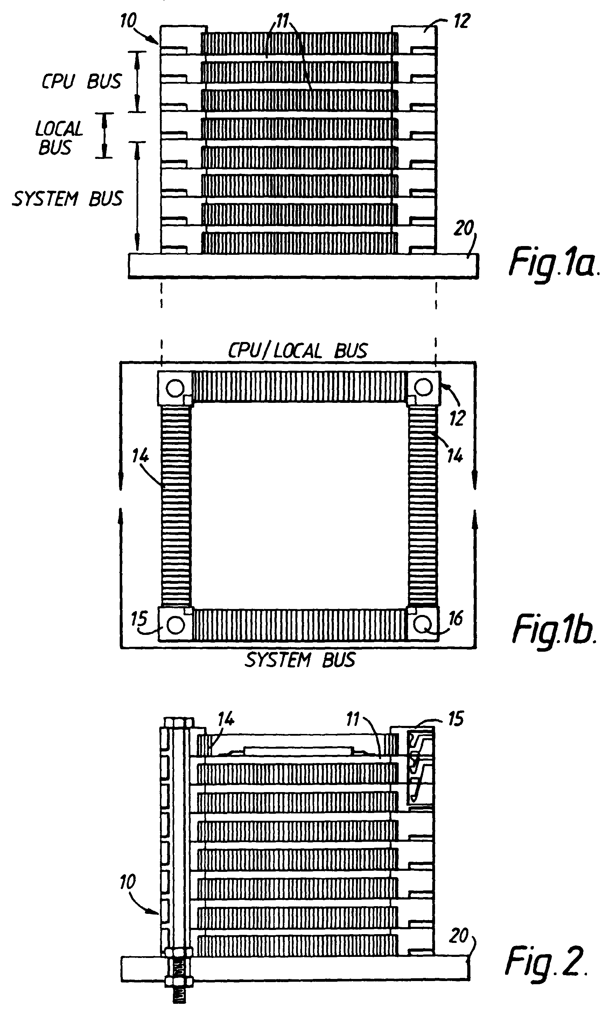

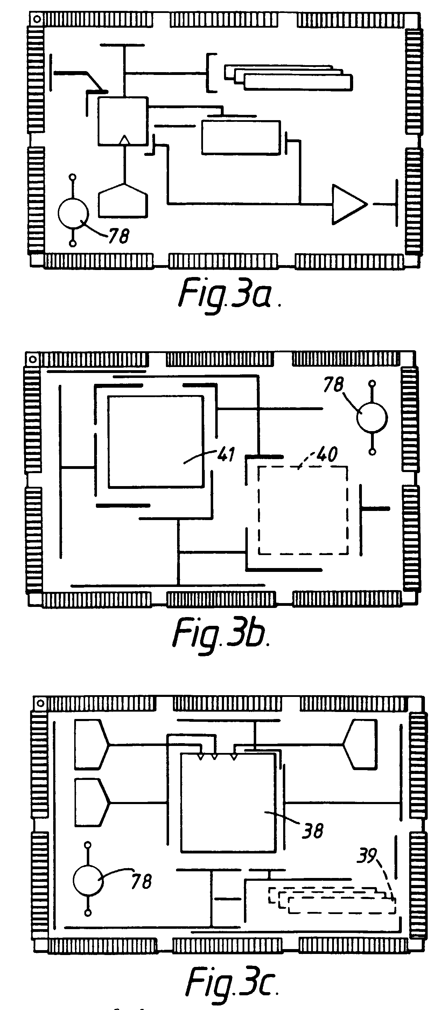

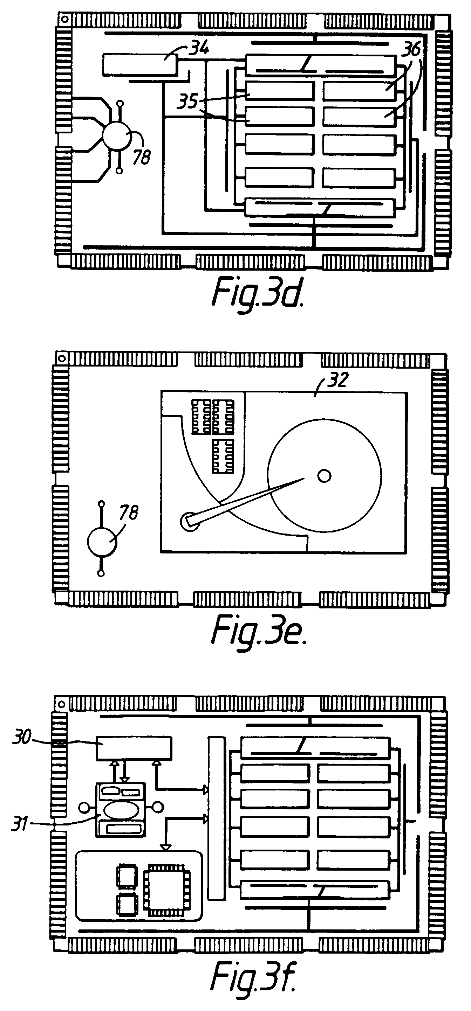

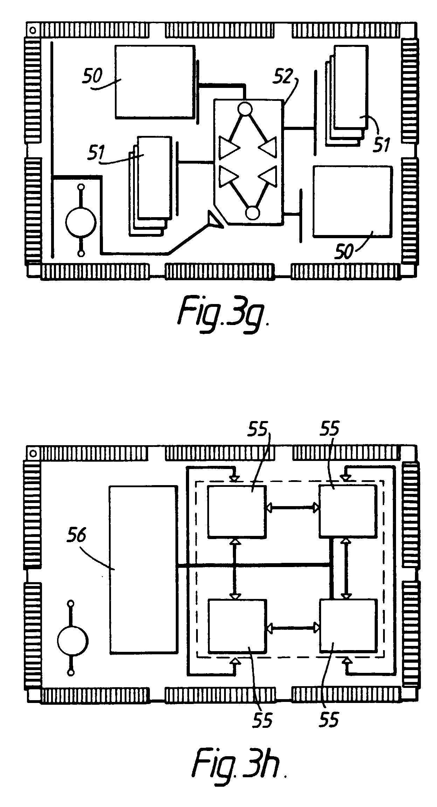

Referring to Figs. 1, 2 and 3, data handling circuitry is formed as a 3-dimensional stack 10 formed by a number of substrates 11 each of which constitutes a level or deck of the stack. Each substrate 11 contains one or more circuit element as will be described in more detail with reference to Fig. 3 and each layer is coupled to its immediately adjacent layer or layers by means of a spacer 12 bearing a multiplicity of coupling means on each side of the spacer. Each spacer is preferably a rectangular frame-like connector device sold as a "Chiprack" connector by Harwin Plc and is more specifically described in GB-A-2191896. For simplicity, one such connector is shown in Figs. 1b and 2 with the contacts which form the coupling means indicated by the reference numerals 14, the insulating frame being indicated by the reference numeral 15 and the reference number 16 indicating holes which can receive screws or bolts extending the height of the stack for clamping all the connectors together when the stack is completed, if necessary. Alternatively, the spacers 12 can provided with snap fittings which allow adjacent spacers to be clipped together eg. projecting resilient figures being received in recesses in adjacent spacers and engaging with projections in the recess.

Each of the substrates forming the decks or layers of the arrangement is of identical shape and size but the circuit elements contained on each substrate can vary considerably to such an extent that a single substrate can have provided on it sufficient circuitry to perform a specific function or alternatively more than one substrate can connect to another substrate in order to form a much larger circuit for performing a specific function.

In this application, the term "bus" is used to indicate conductors carrying signals at a specified rate. A system bus is thus one carrying signals at a rate compatible with a complete system and this rate is usually the lowest rate and/or smallest number of bits in a byte e.g. eight. In conventional computer architecture this is the rate at which peripherals and input and output devices communicate with the system.

A CPU bus operates at the same rate as the processor which is the highest data rate and also the largest number of bits in a byte e.g. thirty two bits.

With conventional architecture, the different bus rates are buffered using core logic but this has the effect that at times the processor may have to wait before carrying out further instructions. The core logic can determine and control memories to more efficiently handle data from the CPU and this is normally done at a rate intermediate the CPU rate and the system rate. Conventionally, conductors carrying signals at this intermediate rate are termed the "local bus".

While the basic "Chiprack" connector system is extremely flexible from the design point of view, it has been found necessary to very carefully define and design the overall circuitry contained within a stack of substrates so as to avoid bus contention and signal propagation delay problems. To this end, as is indicated in Fig. 1a, the lower most deck or decks are connected together by the system bus which then extends on to a printed circuit board 20 on which the stack is mounted. Those circuit elements requiring only a local bus, ie. within the stack, are then mounted on the decks above the lower most decks and are connected together using the chip rack connectors which form the local bus. The topmost decks or layers can then be even more device specific and could be used by processing layers, for example.

The 3-dimensional nature of the design is such that not only can the system and local buses be vertically separated one from the other but they can also be separated in a horizontal direction as indicated in Fig. 1b so that the connectors constituting the system bus can occupy, for example, two sides of the stack while the local bus is constituted by the connectors on the other two sides of the stack. This horizontal and vertical separation of the local and system buses has been found to be extremely effective.

Fig. 3 shows more specifically how one could construct a processor utilizing the stacking concept and bus definition concept described in relation to Figs. 1a and 1b. Although seven decks are shown in Fig. 1a, this is for diagrammatic explanation purposes only and Fig. 3 shows eight decks any desired data handling circuitry can be assembled from these eight decks although in some cases a deck, such as a memory deck may need to be duplicated. The individual decks are shown as having a rectangular shape with each side being constituted by a number of discrete areas there being three discrete areas on the long side of the rectangle and two discrete areas on the short side. Each of the areas, indicates discrete connector pads for engagement with corresponding contacts on the spacer frames. The bottom-most substrate is shown in Fig. 3f and this bottom-most substrate includes a communication matrix protocol resource controller (CMPRC) 30 and a power management unit 31 for the stack. All system communication is through this particular level which is directly connected to the mother board. This level carries out the management of the system resources, communication between stacks, safeguards against bandwidth problems and to bus contention. The CMPRC 30, which will be described in more detail later, comprises an intelligent processor arrangement which relieves the main processor of the operation of allocating addresses to data and finding storage units capable of receiving the data and also retrieving the data. Such a circuit can be built using conventional devices or can be fabricated as a custom chip or as a transputer. The power management unit monitors power consumption for the stack and if it detects that the stack is not in use then it can reduce power to a standby level. Each check can be provided with its own power management unit but in this case only one provides clocks. This is particularly useful in hand-held devices or any other application where power is an important factor in the final product specification.

The layers above this base layer will be determined both in number and in constitution by the exact function which must be carried out by the stack. The layers shown in Fig. 3 in combination constitute a processing engine and the next layer from the bottom, as shown in Fig. 3e, is a mass storage layer which could for example consist of a small hard disk unit 32. This particular layer is optional. The next layer which is shown in Fig. 3d is an integrated peripheral manager unit 34 which controls peripheral devices such as the mass storage unit directly below it or any other parallel or series devices, bus mouse devices and floppy drive units. Also on this deck is situated, if needed, a real time clock 35 and a keyboard controller 36. Fig. 3c shows the next layer which in this case is an integrated system device 38 and default memory device 39 which are constituted by VLSI devices which contain all the circuits which are needed except the processor itself to form a basic computer. Such devices may come in a single VLSI chip or in a plurality of chips. Fig. 3c shows the single chip solution. Also on this layer are a plurality of memory chips which constitute the default memory, this particular layer also constitutes the boundary of the system bus and all layers above the integrated system device layer connect with the local bus.

As indicated, the processor itself is on the layer above the ISD layer and is shown in Fig. 3b. In this figure, the processor is shown as constituted by a main processor 40 accompanied by a co-processor 41.

The uppermost layer is constituted by a video unit shown in Fig. 3a which in this case is indicated as being constituted by a five piece chip set. This layer controls a variety of visual display units such as a monitor.

In addition to the above decks, Figs. 3g and 3h show other decks which in combination with one or more of the decks in Figs. 3a to 3f will enable constructions of any desired data handling circuitry.

Fig. 3g is a swing store multi processor deck comprising slave processors 50, swing store memory devices 51 and muliplexer switches 52.

Fig. 3h is a deck carrying configurable logic arrays 55 and a controller 56 which is similar to the circuit shown in Figs. 3d.

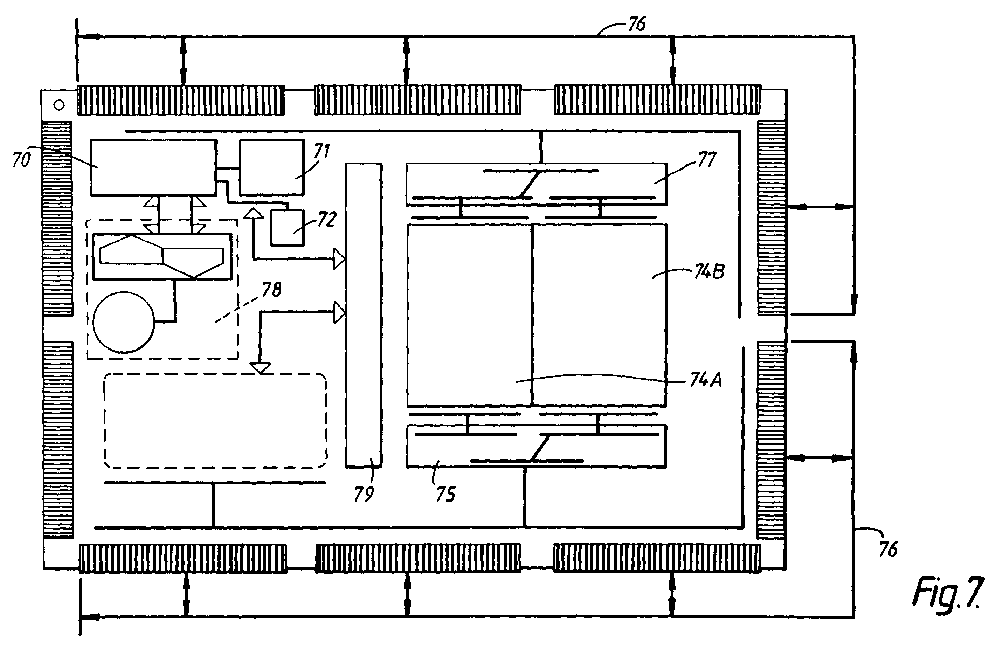

The arrows shown in Fig. 3 indicate data paths between chips on a layer and between layers. Each layer is provided with a power management unit which is shown in more details in Fig. 7.

The CMPRC 30 is an important constituent of the present invention and is more clearly shown in Fig. 7 which is a block diagram of the circuit.

The CMPRC is based on a suitable processor 70 which has on-board memory 71 which contains the basic instructions which the processor has to carry out. There is also a reconfigurable logic circuit 72 which can be temporarily altered so that the CMPRC can change its configuration and communicate with any peripheral device or main processor. Also connected to the processor 70 are a plurality of memories 74A and 74B of which two are shown connected by a switch 75 and a switch 77. The switches 75 and 77 are controlled by a multiplexing switch connected to the processor 70.

This arrangement permits data coming in to the CMPRC on I/o lines 76 to be stored in one memory while the other memory is being read and its data output via switch 77.

Fig. 7 shows the CMPRC as having a virtual earth power management unit 78. This unit comprises a constant current power supply unit and a current regulator. The current regulator is in the form of a tuned circuit where the range of tuned frequencies correspond to the range of clock frequencies in use by the circuit assembly. The power management unit is arranged to provide a virtual earth source.

The on-board memory 71 contains the basic protocol for the CMPRC and this protocol will determine the overall functioning of the CMPRC which will in turn depend on whether there is only one CMPRC per stack or more than one CMPRC in a stack or whether there is more than one stack needed in order to provide a particular function. Thus, CMPRC's may need to communicate with each other as well as with peripheral devices and memories.

CMPRC's are extremely useful as they can buffer data which has to be input at one rate and output at a different rate. It is thus possible to construct a processing engine where the devices on CPU bus form one stack with a CMPRC as the bottom layer which communicates with one or more other stacks at the same or different but rates, the other stacks also having the CMPRC layers as their respective bottom layer.

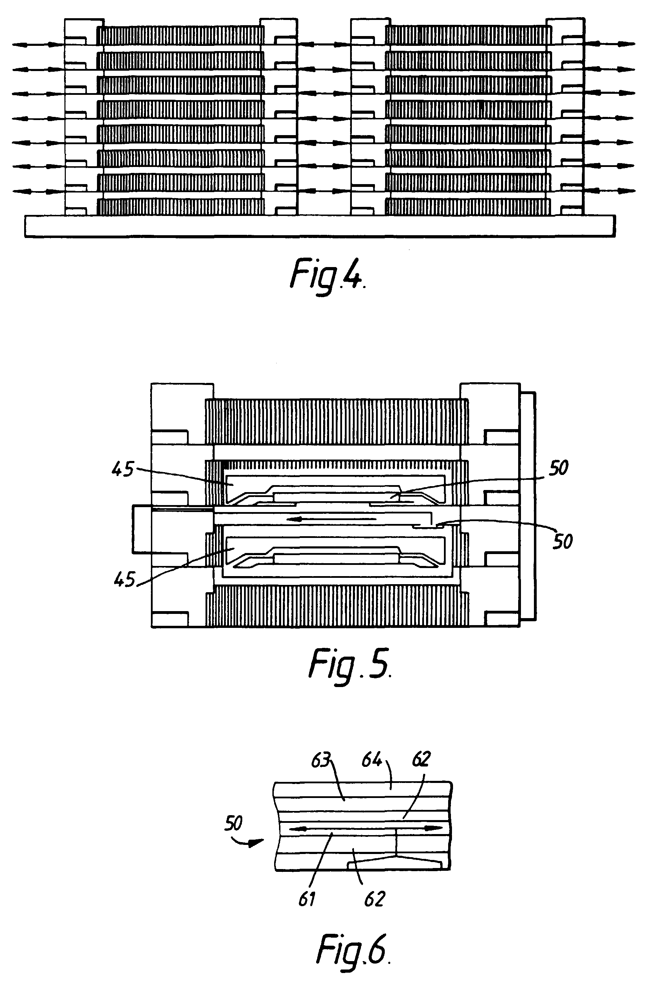

It will be appreciated that while a single stack has been described as performing a specific function such as a processing engine, a number of stacks can be located on a single mother board and can communicate with each other through the CMPRC layer which is present at the bottom of each stack. However, as shown in Fig. 4, stacks can communicate with each other in other ways depending on the functions being performed by the individual stacks. It is possible for stacks to communicate at levels other than the base level as indicated by the arrows and in any convenient manner such as by optical transmission or by being hard wired. Thus, for example, different stacks requiring only local bus level communications can be directly connected together at the local bus level without the signals having to travel down one stack on to the mother board and up the other stack.

It will be appreciated that because the stacks are created by individual small circuit boards connected together by a spacers which are made a unified whole either by the individual connectors interlocking with each other or by bolts or screws passing down the holes in the insulating frames, the stack or stacks can be broken apart so as to replace individual substrates and then reassembled. This permits not only efficient and cost effective repair but also efficient upgrading in view of the fact that, for example, new processors can be accommodated simply by replacing the processor layer and by replacing the CMPRC layer if necessary. It will be appreciated that the substrates constituting each individual layer need not be soldered or in any way permanently connected to the connectors unless this is specifically desired. Electrical connection is achieved simply by a pressure contact between the contacts on the spacer frames mating with connector pads or the like on the substrates. The full assembly is thus readily taken apart and re-assembled.

One potential problem which a stack may have is the problem of heat dissipation. It should be kept in mind that each layer, rather than being single sided as shown in Fig. 2, could be double sided i.e. electrical components can be located on both sides of the substrate in which case extremely high packing densities are feasible.

High packing densities are desirable but do result in heat dissipation problems. It is well known that semiconductor circuit devices operate best at moderate temperatures and therefore heat dissipation is an important consideration. As shown in Fig. 5, the space between each substrate in a stack can be filled wholly or partially with thermally conductive material 45 or any suitable thermally conductive arrangement so as to transfer heat in a direction from the centre of the substrates to the edges where the thermally conductive arrangements, whatever they are, can make contact either with the screws or bolts passing through the frames forming the different layers or to specifically dedicated contacts extending the fully height of the stack. Heat from the stack is transferred to the mother board and can then be dissipated or in fact can dissipate from the contacts on the exterior of each individual frame connector.

Fig. 6 shows diagrammatically, and to a much larger scale, how heat can be transferred from the centre of a layer to the edge of the frame connector either additionally or as an alternative to the provision of thermally conductive material between decks. It is preferred that each substrate is constituted by a multi-layer board 50 as is shown in rig. 6. The central layer 61 is a ground layer which is both electrically and thermally conductive. On either side of the ground layer but electrically insulated therefrom are signal layers 62 and a voltage layer 63 for carrying rail voltages. The outer-most layers 64 are insulating. Heat is conducted through the blank, signal and voltage layers to the ground layer 61 where it then spreads out towards the periphery of the layer where contact is made with the ground power contacts on the spacer. If the ground layers connects with any clamping screws or bolts then these in turn form part of the heat transfer change which allows heat to be efficiently removed from each individual layer and transferred to the mother board 20 or directly to the atmosphere.

The above description has been of a stack operating as a processor rather akin to a conventional processor. It is possible to construct other devices such as an array processor which is in fact a collection of discrete processors interconnected in such a way as to perform calculations very quickly. Such a processor has no bus structure as described above. All processors operate outside the CPU bus rate. However, using a stacking construction such as is described above, a CMPRC is always present as the bottom-most layer. The CMPRC controls the temporary storage of data as well as communications with the mother board and the other stacks.

More than one CMPRC can be present in which case layers other than the bottom-most layer can contain a CMPRC. This is particularly useful for inter-stack communications.

It is to be emphasized that the invention is not limited to any particular circuit configuration or operation nor to any particular size either of stack height or stacked area. It is preferred to utilise a rectangular construction with 120 individual contacts on the long side of the stack and 80 contacts on the short side. Each side is divided into groups of 40 contacts and between each group of contacts a clamping screw or bolt can be located in holes in the insulating frame. This has been found to produce an efficient and ridged structure. Also, while the arrangement is principally designed for handling digital signals, analog signals can also be handled.

Further, while the CMPRC has been described as being a layer of each stack, it is possible for the CMPRC to be all or part of the circuitry on the mother board.

Another alternative is to use optical couplings in place of the electrical contacts on the spacers for coupling the different decks together.

## Claims

1. Computer data handling apparatus comprising a substrate and at least one circuit arrangement mounted on the substrate, the circuit arrangement comprising a plurality of stackable spacers made of insulating material and each being provided with a plurality of coupling means for coupling a circuit board carried by the respective spacer with adjacent spacers above and below the respective spacer characterized in that a control circuit for controlling allocation of resources is present in the bottom circuit board of the stack, in that data buses are formed by selected coupling means of the spacers and the buses are arranged with the most general, slowest bus at the bottom and the fastest bus at the top of the stack, in that system and local buses are separated in the horizontal direction and in that a power management unit for the stack is also provided in the bottom circuit board of the stack.

2. Apparatus according to claim 1, wherein each data bus extends around at least a substantial part of each spacer.

3. Apparatus according to claim 1 or 2, wherein each spacer is rectangular and the coupling means on at least two opposite sides are combined in groups.

4. Apparatus according to any one of the preceding claims, wherein the spacers are connected together to form a unitary stack.

5. Apparatus according to claim 4, wherein the stack is formed by cooperating snap fittings on the spacers which allow adjacent spacers to be snapped together.

6. Apparatus according to claim 4, wherein a torque member extending the height of the stack is used to clamp the spacers together.

7. Apparatus according to any preceding claim, wherein there are a plurality of stacks on said substrate and communication between a plurality of stacks is achieved via spacers which are remote from the substrate.

8. Apparatus according to any preceding claim, and comprising heat transfer means including means for transferring heat to the edges of the spacers.

9. Apparatus according to claim 8, wherein the heat transfer means includes heat conductive members extending the height of the stack.

10. Apparatus according to claim 8 or 9, wherein the heat transfer means includes a multi-layer circuit board constituting the circuit board on at least one spacer, one of the layers being heat conductive.

11. Apparatus according to any one of the preceding claims wherein the coupling means comprise an electrically conductive contact.

12. Apparatus according to any one of the preceding claims, and comprising a power management unit on at least one further substrate, each power management unit comprising a constant current power source and a shunt regulator.

13. Apparatus according to claim 12, wherein the power management unit is arranged to provide a virtual earth reference.

14. Apparatus according to claim 12 or 13, and comprising multiple clock frequency sources, the bandwidth of the shunt regulator corresponding to the upper and lower frequencies of the clock sources.

15. Apparatus according to claim 12, 13 or 14 wherein there is a power management unit on each of the plurality of substrates whereby to provide a distributed power supply.

## Patentansprüche

1. Computerdatenverarbeitungsanlage, umfassend ein Substrat und wenigstens eine auf dem Substrat montierte Schaltungsanordnung, die eine Mehrzahl von stapelbaren Abstandshaltern aus Isoliermaterial umfaßt, die jeweils mit einer Mehrzahl von Kopplungsmitteln zum Verkoppeln einer Leiterplatte, die von dem jeweiligen Abstandshalter getragen wird, mit benachbarten Abstandshaltern über und unter dem jeweiligen Abstandshalter ausgestattet sind, dadurch gekennzeichnet, daß eine Steuerschaltung zum Steuern der Zuweisung von Ressourcen in der untersten Leiterplatte des Stapels vorhanden ist, dadurch, daß Datenbusse durch gewählte Kopplungsmittel der Abstandshalter gebildet werden und die Busse mit dem allgemeinsten, langsamsten Bus ganz unten und dem schnellsten Bus ganz oben auf dem Stapel angeordnet sind, dadurch, daß System- und Local-Busse in horizontaler Richtung voneinander getrennt sind, und dadurch, daß auch eine Leistungsmanagementeinheit für den Stapel in der untersten Leiterplatte des Stapels vorgesehen ist.

2. Anlage nach Anspruch 1, bei der jeder Datenbus um wenigstens einen erheblichen Teil jedes Abstandshalters verläuft.

3. Anlage nach Anspruch 1 oder 2, bei der jeder Abstandshalter rechteckig ist und die Kopplungsmittel an wenigstens zwei gegenüberliegenden Seiten zu Gruppen kombiniert sind.

4. Anlage nach einem der vorherigen Ansprüche, bei der die Abstandshalter miteinander verbunden sind, um einen einheitlichen Stapel zu bilden.

5. Anlage nach Anspruch 4, bei der der Stapel durch zusammenwirkende Einschnappteile an den Abstandshaltern gebildet wird, mit denen benachbarte Abstandshalter zusammengesteckt werden können.

6. Anlage nach Anspruch 4, bei der ein Drehmomentelement, das sich über die Höhe des Stapels erstreckt, verwendet wird, um die Abstandshalter aneinander zu befestigen.

7. Anlage nach einem der vorherigen Ansprüche, bei der eine Mehrzahl von Stapeln auf dem genannten Substrat vorhanden ist und die Kommunikation zwischen einer Mehrzahl von Stapeln über Abstandshalter erzielt wird, die von dem Substrat entfernt sind.

8. Anlage nach einem der vorherigen Ansprüche, umfassend Wärmeableitungsmittel zum Ableiten von Wärme zu den Rändern der Abstandshalter.

9. Anlage nach Anspruch 8, bei der das Wärmeableitungsmittel wärmeleitende Elemente beinhaltet, die sich über die Höhe des Stapels erstrecken.

10. Anlage nach Anspruch 8 oder 9, bei der das Wärmeableitungsmittel eine mehrschichtige Leiterplatte beinhaltet, die die Leiterplatte auf wenigstens einem Abstandshalter bildet, wobei eine der Schichten wärmeleitend ist.

11. Anlage nach einem der vorherigen Ansprüche, bei der die Kopplungsmittel einen elektrisch leitenden Kontakt umfassen.

12. Anlage nach einem der vorherigen Ansprüche, umfassend eine Leistungsmanagementeinheit auf wenigstens einem weiteren Substrat, wobei jede Leistungsmanagementeinheit eine Konstantstrom-Leistungsquelle und einen Nebenschlußregler umfaßt.

13. Anlage nach Anspruch 12, bei der die Leistungsmanagementeinheit so angeordnet ist, daß eine virtuelle Erdreferenz erhalten wird.

14. Anlage nach Anspruch 12 oder 13, umfassend mehrere Taktfrequenzquellen, wobei die Bandbreite des Nebenschlußreglers der oberen und der unteren Frequenz der Taktquellen entspricht.

15. Anlage nach Anspruch 12, 13 oder 14, bei der eine Leistungsmanagementeinheit auf jedem aus der Mehrzahl von Substraten vorhanden ist, um so eine verteilte Stromversorgung bereitzustellen.

## Revendications

1. Appareil de traitement de données englobant un substrat et au moins une configuration de circuits montée sur le substrat, la configuration de circuits englobant une pluralité de pièces d'écartement empilables réalisées en un matériau isolant et chacune étant dotée d'une pluralité de moyens d'accouplement pour accoupler une carte de circuits imprimés portée par la pièce d'écartement respective avec des pièces d'écartement adjacentes au-dessus et au-dessous de la pièce d'écartement respective, caractérisé en ce qu'un circuit de commande pour commander l'affectation des ressources est présent dans la carte de circuits imprimés inférieure de la pile, en ce que des bus de données sont formés par des moyens d'accouplement sélectionnés des pièces d'écartement et les bus sont agencés avec le bus le plus général et le plus lent en bas et le bus le plus rapide en haut de la pile, en ce que le système et les bus locaux sont séparés dans la direction horizontale et en ce qu'une unité de gestion d'énergie pour la pile est également prévue sur la carte de circuits imprimés inférieure de la pile.

2. Appareil selon la revendication 1, dans lequel chaque bus de données s'étend autour d'au moins une partie substantielle de chaque pièce d'écartement.

3. Appareil selon la revendication 1 ou 2, dans lequel chaque pièce d'écartement est rectangulaire et les moyens d'accouplement sur deux côtés opposés au moins sont combinés en groupes.

4. Appareil selon l'une quelconque des revendications précédentes, dans lequel les pièces d'écartement sont connectées ensemble pour former une pile unitaire.

5. Appareil selon la revendication 4, dans lequel la pile est formée par coopération de fixations à encliquetage sur les pièces d'écartement qui permettent d'encliqueter ensemble des pièces d'écartement adjacentes.

6. Appareil selon la revendication 4, dans lequel un élément à couple de serrage qui s'étend sur toute la hauteur de la pile est utilisé pour serrer ensemble les pièces d'écartement.

7. Appareil selon l'une quelconque des revendications précédentes, dans lequel il y a une pluralité de piles sur ledit substrat et la communication entre une pluralité de piles est obtenue par l'intermédiaire de pièces d'écartement qui sont écartées du substrat.

8. Appareil selon l'une quelconque des revendications précédentes, englobant des moyens de transfert de chaleur, y compris des moyens pour transférer la chaleur aux bords des pièces d'écartement.

9. Appareil selon la revendication 8, dans lequel les moyens de transfert de chaleur englobent des éléments conducteurs de chaleur qui s'étendent sur toute la hauteur de la pile.

10. Appareil selon la revendication 8 ou 9, dans lequel les moyens de transfert de chaleur englobent une carte de circuits imprimés multicouches constituant la carte de circuits imprimés sur au moins une pièce d'écartement, l'une des couches étant conductrice de chaleur.

11. Appareil selon l'une quelconque des revendications précédentes, dans lequel les moyens d'accouplement englobent un contact conducteur d'électricité.

12. Appareil selon l'une quelconque des revendications précédentes, et englobant une unité de gestion d'énergie sur au moins un autre substrat, chaque unité de gestion d'énergie comportant une source d'énergie à courant constant et un régulateur en parallèle.

13. Appareil selon la revendication 12, dans lequel l'unité de gestion d'énergie est agencée pour fournir une référence de masse virtuelle.

14. Appareil selon la revendication 12 ou 13, et englobant plusieurs sources de fréquence d'horloge, la bande passante du régulateur parallèle correspondant aux fréquences supérieure et inférieure des sources de fréquence d'horloge.

15. Appareil selon la revendication 12, 13 ou 14, dans lequel il existe une unité de gestion d'énergie sur chacun de la pluralité de substrats de manière à fournir une alimentation en énergie répartie.
